# EUROPÄISCHE PATENTSCHRIFT

(11) **EP 2 796 015 B1**
(45) Veröffentlichungstag und Bekanntmachung des Hinweises auf die Patenterteilung: **21.10.2015**
(21) Anmeldenummer: 12795762.9
(22) Anmeldetag: 20.11.2012
(51) Int. Cl.: H05K 3/28, H05K 3/34, F16H 61/00, H05K 1/02

(54) **STEUERGERÄT FÜR EIN KRAFTFAHRZEUG**
CONTROL DEVICE FOR A MOTOR VEHICLE
APPAREIL DE COMMANDE POUR UN VÉHICULE AUTOMOBILE

(30) Priorität: 21.12.2011 DE 102011089465
(43) Veröffentlichungstag der Anmeldung: 29.10.2014
(73) Patentinhaber: Robert Bosch GmbH, 70442 Stuttgart (DE)
(72) Erfinder: DROIGK, Thorsten, 71640 Ludwigsburg (DE)
(86) Internationale Anmeldenummer: PCT/EP2012/073056
(87) Internationale Veröffentlichungsnummer: WO 2013/092070

(56) Entgegenhaltungen:
- DE-A1-102007 032 535
- JP-A- 10 168 434
- KR-B1- 101 008 310

## Beschreibung

### Stand der Technik

Zur Steuerung von diversen Anwendungen im Kraftfahrzeugbau sind elektronische Steuerungsgeräte erforderlich. Die elektronischen Steuergeräte enthalten elektronische Bauelemente wie Steuermodule zum Ansteuern von Aktuatoren und Sensoren sowie wenigstens eine Steckverbindung zum Anschluss an einen Fahrzeugkabelbaum. Derartige Steuerungsmodule sind zur Steuerung von Schaltvorgängen moderner Automatikgetriebe erforderlich, die in vielen Fällen im Inneren des Getriebegehäuses angeordnet sind. Hierbei werden die Steuerungsmodule so verbaut, dass sie ganz oder teilweise von Getriebeöl bedeckt sind und Temperaturen von -40 °C bis +150 °C, die in derartigen Getrieben auftreten können, ausgesetzt sind. Um die Anschlusspins der Steuerungsmodule, respektive der elektronischen Bauelemente vor Metallspänen zu schützen, die bei einer gleichzeitigen Berührung von zwei Anschlusspins einen Kurzschluss erzeugen könnten, werden die Anschlusspins mittels eines sogenannten Spanschutzdeckels geschützt, der zum einen das elektronische Bauelement umgibt und zum anderen auf der Leiterplatte aufliegt. In der Regel wird dieser Spanschutzdeckel mittels einer Druckfeder an die Leiterplatte angedrückt, so dass der Spanschutzdeckel spaltfrei an der Leiterplatte anliegt. In dem Spanschutzdeckel sind ferner Trennstege angeordnet, die die einzelnen benachbarten Anschlusspins voneinander trennen. Aufgrund von Temperaturbelastung von -40°C bis +150°C kann es zu einer irreversiblen Verformung der verwendeten Komponenten kommen, so dass nicht auszuschließen ist, dass der Spanschutzdeckel nicht mehr spaltfrei an der Leiterplatte anliegt. Hierdurch kann nicht nur Automatikgetriebeöl, welches als solches elektrisch isolierend ist, eindringen, sondern auch sogenannter Ölschlamm. In diesem Ölschlamm können sich elektrisch leitfähige Partikel oder Schwebstoffe befinden, die sich an den Trennwänden des Spanschutzdeckels und/oder an den Anschlusspins ablagern können. Dies kann dazu führen, dass zwischen zwei benachbarten Anschlusspins Kriechstrompfade entstehen, die möglicherweise zu einem Kurzschluss führen.

Aus der DE 10 2007 032 535 A1 (vergl. den Oberbegriff des Anspruchs 1) ist eine elektronische Anordnung mit einem elektronischen Bauteil und mit einem ersten Anschlusspin und einem zweiten Anschlusspin und einer Leiterplatte bekannt, wobei der erste Anschlusspin und der zweite Anschlusspin je mit der Leiterplatte elektrisch leitfähig verbunden sind. Durch eine Öffnung in einem Gehäusedeckel ist eine das Bauteil und die Anschlusspins abdeckende Vergussmasse eingefüllt.

Aus der KR 101 008 310 B1 eine keramisch Chip-Vorrichtung bekannt, die einen keramischen Chip und zwei metallische Anschlusselemente aufweist, die zum Schutz mit einer polymeren Substanz beschichtet sind.

### Zusammenfassung der Erfindung

Somit kann ein Bedürfnis bestehen, eine elektronische Anordnung bereitzustellen, bei dem ein Kurzschluss aufgrund einer Brückung von Anschlusspins durch eine elektrisch leitfähige Verbindung aus Spänen oder Ablagerungen über die theoretische Lebensdauer der elektronischen Anordnung verhindert ist.

Das Bedürfnis kann befriedigt werden durch die Gegenstände der unabhängigen Patentansprüche. Weitere vorteilhafte Ausgestaltungen der Erfindung ergeben sich aus den abhängigen Patentansprüchen.

Gemäß einem ersten Ausgestaltungsbeispiel der Erfindung wird eine elektronische Anordnung für ein Kraftfahrzeug bereitgestellt. Die elektronische Anordnung weist ein elektronisches Bauelement mit einem ersten Anschlusspin und mit einem zweiten Anschlusspin und eine elektrische Verbindungstruktur auf. Der erste Anschlusspin und der zweite Anschlusspin sind einander benachbart. Der erste Anschlusspin und der zweite Anschlusspin sind je an der elektrischen Verbindungstruktur elektrisch leitfähig verbunden. Durch ein elektrisch nicht leitfähiges, fluidbeständiges und synthetisches Fett ist eine Belegung mit einer elektrisch leitfähige Verbindung zwischen dem ersten Anschlusspin und dem zweiten Anschlusspin verhindert.

Das elektronische Bauelement kann in THT (Through-Hole-Technology) oder SMT (Surface-Mounted-Technology) an die elektrische Verbindungstruktur verbunden sein, wenn die elektrische Verbindungstruktur als flexible oder starre Leiterplatte ausgebildet ist. Wenn die Leiterplatte starr ausgebildet ist, wird sie in der Regel in FR4-Qualität oder höher gefertigt sein. Auch kann die elektrische Verbindungstruktur als ein Stanzgitter, insbesondere ein umspritztes Stanzgitter, ausgebildet sein. Ferner kann die elektrische Verbindungstruktur auch als als MID(molded interconnect devices) oder als elektrische Leitung ausgebildet sein. Zumeist werden mehrere Leitungen zu einem Kabelbaum zusammengefasst, wobei das elektronische Bauelement an die elektrischen Leitungen elektrisch leitfähig verbunden ist. Hierbei kann das elektronische Bauelement auch fliegend an die elektrischen Leitungen elektrisch leitend verbunden sein. In weitestem Sinne kann das elektronische Bauelement auch als wenigstens zwei elektrische Leitungen ausgebildet sein, so dass es sich bei dem elektrisch leitfähigen Verbinden zweier benachbarter Anschlusspins an eine elektrische Verbindungsstruktur auch um zwei benachbarte Leitungsverbindungen handeln kann. Die elektronische Anordnung kann als ein Steuergerät ausgebildet sein. Wenn die elektrische Verbindungsstruktur als eine Leiterplatte und das elektronische Bauelement von einem Bauteilgehäuse umschlossen ist, kann sich der jeweilige Anschlusspin demnach zwischen dem Bauteilgehäuse und der Leiterplatte erstrecken sowie, insbesondere, wenn das elektronische Bauelement mit THT gelötet wurde, auch über eine einer Bauteilseite gegenüberliegende Lötseite der Leiterplatte hinaus. Wenn das elektronische Bauelement mittels SMT an die Leiterplatte verbunden ist, wird sich der jeweilige Anschlusspin lediglich von der Leiterplatte bis zu dem Bauteilgehäuse erstrecken. Die zwischen dem ersten und dem zweiten Anschlusspin zu verhindernde Belegung mit einer elektrisch leitfähigen Verbindung kann beispielsweise durch elektrisch leitfähige Späne wie Metallspäne, Ölschlammpartikel und/oder durch elektrisch leitfähige Ablagerungen erfolgen. Wenn sich die Metallspäne in einem Automatikgetriebe befinden, können diese während des Betriebs des Automatikgetriebes oder auch während der Fertigung des Getriebes entstanden sein. Die elektrisch leitfähigen Ablagerungen können beispielsweise als Schwebstoffe in einem Automatikgetriebeöl enthalten sein. Derartiges mit Schwebstoffen versetztes Automatikgetriebeöl ist auch unter der Bezeichnung Ölschlamm bekannt. Auch können die elektrisch leitfähigen Verbindungen durch ein Niederschlagen von chemischen Reaktionsprodukten, insbesondere von Kupferverbindungen, entstehen. In vorteilhafter Weise können durch das Fett, dessen Bestandteile vollständig synthetisch hergestellt sein können, also keine Produkte auf mineralischer Basis enthalten, die Anschlusspins vor einem elektrischen Kontakt mit derartigen elektrisch leitfähigen Verbindungen geschützt werden. Somit können durch das synthetische Fett auch zwei einander benachbarte elektrisch leitfähige Verbindungen von je zwei elektrischen Leitungen untereinander geschützt werden. Auch kann das Fett, insbesondere bei THT-Bauelementen in Verbindung mit einer Leiterplatte, sowohl an der Bauteilseite als auch an der Lötseite aufgetragen sein. Die im Folgenden beschriebenen Ausführungen können zumindest sinngemäß an zwei einander benachbarten elektrisch leitfähigen Verbindungen von den beiden Anschlusspins des elektronischen Bauelements an die elektrische Verbindungsstruktur realisiert werden. Zum einen kann das Fett zwischen den einander benachbarten Anschlusspins als eine Trennwand ausgebildet sein, die in der Regel höher ist als die beiden einander benachbarten Anschlusspins und zusätzlich die Anschlusspins auch in ihrer Länge überragt. Hierbei ist es nicht erforderlich, dass das Fett die Anschlusspins berührt. Durch eine derartige aus Fett gebildete Trennwand können die elektrisch leitfähigen Späne nicht gleichzeitig zwei Anschlusspins berühren und hierdurch einen Kurzschluss erzeugen. Auch besitzt das Fett eine derartig geringe Oberflächenspannung, dass sich die elektrisch leitfähigen Ablagerungen nicht an dem Fett absetzen können. Somit kann eine Brückenbildung zwischen zwei Anschlusspins aufgrund von Ablagerungen unmöglich sein. Zum anderen können die Anschlusspins vollständig durch das Fett umschlossen sein. Durch eine ausgeprägten Adhäsionskräfte des Fetts können auch zwei benachbarte Anschlusspins durch eine vorbestimmte Fettmenge gemeinsam geschützt werden, ohne dass das Fett sich von einem der Anschlusspins aufgrund unterschiedlicher Komponentenausdehnungen durch Wärme löst. Das Fett ist also zusätzlich zu den zuvor genannten Eigenschaften auch elastisch reversibel verformbar. Das Fett wird in der Regel an dem elektronischen Bauelement und an der elektrischen Verbindungsstruktur fest verbunden sein. Weiterhin kann das Fett auch in Kammern des aus dem Stand der Technik bekannten Deckelelements eingebracht werden, wobei das Deckelelement das elektronische Bauelement überspannt und die Kammern die einzelnen einander benachbarten Anschlusspins voneinander trennt, insbesondere, wenn das elektronische Bauelement als ein Steuergerät ausgebildet ist. Das Fett wird sich aufgrund seiner Adhäsionskräfte von den Kammerwänden und den Anschlusspins über die theoretische Lebensdauer der elektronischen Anordnung nicht lösen. Auch ist das Fett derart hochviskos, dass es in der Regel durch das Getriebeöl nicht möglich ist, das Fett wegzuwaschen oder in das Fett einzudringen. So bleibt die vorbestimmte Viskosität des Fetts, mit der das Fett von dem Hersteller in die Produktion geliefert wurde, also noch bevor das Fett auf die Anschlusspins aufgetragen wurde, über die Lebensdauer des Steuergeräts konstant erhalten.

Gemäß einem weiteren Ausgestaltungsbeispiel der Erfindung ist das Fett dauertemperaturbeständig zwischen -40°C und +150°C.

Damit erfüllt das Fett die Spezifikationen für den Temperaturbereich, über den das Getriebe betriebsbereit sein muss. Ferner kann das Fett die Spezifikationen auch übertreffen, indem es bis 200°C im Dauerbetrieb eingesetzt werden kann.

Gemäß einem weiteren Ausgestaltungsbeispiel der Erfindung setzt sich das Fett aus einem perfluorierten Grundöl und einem fluororganischen Eindicker zusammen.

Somit ist das Fett aus zwei synthetisch hergestellten Grundkomponenten zusammengesetzt. Damit entfällt die Verwendung von Produkten, die auf Basis mineralischer Grundöle beruhen. Damit entfallen auch die mit mineralischen Produkten möglicherweise einhergehende Verharzung sowie deren Säure, die auch jede für sich Schädigungen an Komponenten hervorrufen können, die mit den mineralischen Produkten in Berührung kommen. Ausgangsprodukt für die Produktion von synthetischen Schmierstoffen sind die Kohlenwasserstoffmoleküle des Rohöls. Diese werden durch einen speziellen Prozess in mehrere Teile zerlegt und durch eine Synthese, ähnlich einem Baukasten, wieder neu zusammengesetzt. Somit entstehen Schmierstoffe auf Basis eines Naturprodukts, welche verbesserte Eigenschaften gegenüber Temperatur-, Druck- und Lastbedingungen aufweisen. Im Gegensatz hierzu werden mineralische Grundöle aus Rohöl bzw. den darin vorkommenden Kohlenwasserstoffmolekülen durch Destillation gewonnen, wobei das Öl nicht mittels einer Synthese weiter verändert wird.

Gemäß einem weiteren Ausgestaltungsbeispiel der Erfindung ist das perfluorierte Grundöl Fluorpolyetheröl (PFPE-Öl) und der fluororganische Eindicker pulverförmiges Polytetrafluorethylen (PTFE-Pulver).

Auch Automatikgetriebeöle besitzen in der Regel Perfluorpolyetheröl als Antischaumadditiv. Da es in der Regel in der Anfangsphase nach einem Fettauftrag auf die Anschlusspins zu einer gewissen Ölabscheidung kommen kann, führt eine derartige Ölabscheidung aus dem Fett und dessen Eintrag in das Automatikgetriebeöl in vorteilhafter Weise zu einer Vermehrung des Antischaumadditivs. Über eine Molekülkettenlänge kann die Viskosität des Perfluorpolyetheröls eingestellt werden. Je kürzer die Molekülketten sind, desto niedrigviskoser, also flüssiger ist das Perfluorpolyetheröl. Somit kann bei gleichem Gewichtsanteil des pulverförmigen Polytetrafluorethylens in einer vorbestimmten Ölmenge die Viskosität des Fetts mittels der Molekülkettenlänge des Perfluorpolyetheröls eingestellt werden.

Gemäß einem weiteren Ausgestaltungsbeispiel der Erfindung weist das perfluorierte Grundöl der elektronischen Anordnung eine Viskosität auf, die größer als 100mm²/s bei 40°C ist.

Gemäß einem weiteren Ausgestaltungsbeispiel der Erfindung weist das perfluorierte Grundöl eine Viskosität auf, die größer als 300mm²/s bei 40°C ist.

Gemäß einem weiteren Ausgestaltungsbeispiel der Erfindung weist das Fett eine Viskosität von 1 bis 6 nach NLGI-Klasse auf.

Die Konsistenzklasse wird gemäß DIN 15818 bzw. NLGI-Klasse verwendet.

Gemäß einem weiteren Ausgestaltungsbeispiel der Erfindung weist das Fett eine Viskosität von 2 bis 3 nach NLGI-Klasse auf.

Gerade diese Viskosität erlaubt es, dass das Fett eigenstabil an den Anschlusspins haftet, obzwar es vom Automatikgetriebeöl umspült sein kann. Auch wird durch die Ölumspülung das Fett nicht weggeschwemmt, wenn es quasi als Trennwand zwischen zwei einander benachbarten Anschlusspins angeordnet ist.

Gemäß einem weiteren Ausgestaltungsbeispiel der Erfindung ist ein die elektrische Verbindungsstruktur umgebendes Fluid Automatikgetriebeöl.

Gemäß einem weiteren Ausgestaltungsbeispiel der Erfindung ist das Fett an den ersten Anschlusspin und/oder an den zweiten Anschlusspin fest verbunden.

Die feste Verbindung kann durch die ausgeprägten Adhäsionskräfte des Fetts erzeugt werden. In einer vorteilhaften Weise sind hierdurch die Anschlusspins vor einer Fluidbenetzung geschützt. Auch können die Anschlusspins nicht durch elektrisch leitfähige Späne gebrückt werden, da die elektrisch leitfähigen Späne nicht durch das die Anschlusspins schützende Fett hindurchdringen können. In der Regel werden alle Anschlusspins derart in das Fett eingebettet sein, dass das Fluid nicht an die Anschlusspins gelangen kann.

Gemäß einem weiteren Ausgestaltungsbeispiel der Erfindung erstreckt sich das Fett trennwandartig zwischen dem ersten Anschlusspin und dem zweiten Anschlusspin an der elektrischen Verbindungsstruktur, wobei das Fett von dem ersten Anschlusspin und dem zweiten Anschlusspin beabstandet ist.

Hierdurch können zwar die Anschlusspins von dem Fluid, respektive dem Automatikgetriebeöl, umspült werden, jedoch wird die Belegung mit der elektrisch leitfähigen Verbindung durch Späne verhindert, da die Höhe sowie die Länge des Fettauftrags die Höhe und die Länge der Anschlusspins in der Regel übersteigt. Aufgrund der geringen Oberflächenspannung des Fetts können sich ferner keine elektrisch leitfähigen Ablagerungen an dem Fett ausbilden, die einen Kurzschluss zwischen zwei benachbarten Anschlusspins hervorrufen könnten. Auch kann das Fett an einem festen Körper derart aufgetragen sein, dass das Fett den festen Körper vollständig umschließt und durch den festen Körper und das Fett eine Trennwandausgebildet ist. Beispielsweise kann der feste Körper bereits als Trennwand beispielsweise aus Kunststoff ausgebildet sein. Beispielsweise kann die Trennwand auch in einem Deckelelement ausgebildet sein, wobei das Fett an die Trennwand in dem Deckelelement aufgetragen wird. Dieses zumindest teilweise mit Fett gefüllte Deckelelement kann dann über das elektronische Bauelement gestülpt werden.

Gemäß einem weiteren Ausgestaltungsbeispiel der Erfindung ist ein Deckelelement mit der elektrischen Verbindungsstruktur verbunden, wobei das Deckelelement und die elektrische Verbindungsstruktur einen Innenraum begrenzen. Das elektronische Bauelement ist in dem Innenraum angeordnet. Durch das Deckelelement können die oben beschriebenen Fettanordnungen wirkungsvoll geschützt werden, so dass beispielsweise während der Montage oder der Demontage des Steuergeräts der Fettaufbau durch die entsprechende Serviceperson nicht geschädigt wird. Natürlich kann auch der gesamte Innenraum mit dem Fett ausgefüllt sein. Dies kann möglicherweise die Montage des Deckelelements beispielsweise an die Leiterplatte erleichtern. Das Deckelement kann jedoch auch an andere Ausformungen der elektrischen Verbindungsstruktur verbunden werden wie beispielsweise Stanzgitter oder MID.

Gemäß einem weiteren Ausgestaltungsbeispiel der Erfindung ist ein Deckelelement mit der elektrischen Verbindungsstruktur verbunden, wobei das Deckelelement und die elektrische Verbindungsstruktur einen Innenraum begrenzen. Der Innenraum ist von einem Außenraum umschlossen. Das elektronische Bauelement ist in dem Innenraum angeordnet. Das Fett ist an dem Gehäuseelement und der elektrischen Verbindungsstruktur umlaufend derart fest verbunden, dass kein Fluid von dem Außenraum in den Innenraum gelangen kann.

Somit kann das Fett quasi als Dichtelement zwischen dem Deckelelement und der elektrischen Verbindungsstruktur verwendet werden. Hierzu kann das Deckelelement beispielsweise wannenartig ausgeformt sein und beispielsweise an der der elektrischen Verbindungsstruktur zugewandten Seite einen entsprechenden Rand zur Aufnahme des umlaufend angeordneten Fetts aufweisen. Aufgrund der Adhäsionskräfte des Fetts sind an dem Deckelelement keine weiteren Elemente erforderlich, die das Fett stabilisieren oder ein Wegschwemmen des Fetts durch das Fluid verhindern müssten.

Gemäß einem weiteren Ausgestaltungsbeispiel der Erfindung ist die elektrische Verbindungsstruktur des Steuergeräts ausgewählt aus der Gruppe von starre Leiterplatte, flexible Leiterplatte, Stanzgitter, umspritztes Stanzgitter, MID(Molded interconnect devices) und wenigstens zwei elektrische Leitungen.

Unter MID wird eine elektrische Verbindungsstruktur verstanden, bei der metallische Leiterbahenn auf einen spritzgegossenen Kunststoffträger aufgetragen sind. Die elektrische Verbindungsstruktur, insbesondere bezüglich Stanzgitter, umspritztes Stanzgitter und MID, kann auch dreidimensional ausgestaltet sein. Wenn die wenigstens zwei elektrischen Leitungen als elektrische Verbindungsstruktur gewählt sind, so wird es sich in der Regel um einen Kabelbaum mit einer Vielzahl von elektrischen Leitungen handeln. Hierbei können die elektronischen Bauelemente in bekannter Form mit den einzelnen Leitungen elektrisch leitfähig verbunden werden, wobei unter einem elektronischen Bauelement in weitestem Sinne auch eine elektrische Leitung verstanden werden kann.

Gemäß einem weiteren Ausgestaltungsbeispiel der Erfindung wird ein Automatikgetriebe mit einer im Vorhergehenden beschriebenen elektronischen Anordnung bereitgestellt. Das Automatikgetriebe weist ein Getriebegehäuse auf, wobei die elektronischen Anordnung innerhalb des Getriebegehäuses angeordnet ist.

Gemäß einem weiteren Ausgestaltungsbeispiel der Erfindung wird ein Fett aus Perfluorpolyetheröl (PFPE-Öl) und pulverförmigem Polytetrafluorethylen (PTFE-Pulver) für eine elektronischen Anordnung für ein Kraftfahrzeug zum Schutz von wenigstens einem Anschlusspin eines elektronischen Bauelements vor einer Belegung mit einer elektrisch leitfähigen Verbindung verwendet.

Gemäß einem weiteren Ausgestaltungsbeispiel der Erfindung ist die elektrisch leitfähige Verbindung eine Kupferverbindung.

Es wird angemerkt, dass Gedanken zu der Erfindung hierin im Zusammenhang mit einer elektronischen Anordnung für ein Kraftfahrzeug, einem Automatikgetriebe mit einer diesbezüglichen elektronischen Anordnung und einer Verwendung eines Fetts für eine elektronische Anordnung beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Figur 1: zeigt eine elektronische Anordnung mit einem Anschlusspins aufweisenden elektronischen Bauelement und mit einer als Leiterplatte ausgebildeten elektrischen Verbindungsstruktur, wobei die Anschlusspins an der Leiterplatte gemäß dem Stand der Technik elektrisch leitfähig verbunden sind, in einer 3D-Ansicht;
- Figur 2: zeigt die aus Figur 1 bekannte elektronische Anordnung, bei dem die Anschlusspins mit Fett derart umschlossen sind, dass die Anschlusspins nicht erkennbar sind, in einer 3D-Ansicht;
- Figur 3: zeigt die aus Figur 2 bekannte elektronische Anordnung, dessen elektronisches Bauelement von einem mit einer Leiterplatte verbundenem Deckelelement umschlossen ist, in einer 3D-Ansicht;
- Figur 4: zeigt die aus Figur 3 bekannte elektronische Anordnung im Querschnitt in einer 3D-Ansicht;
- Figur 5: zeigt eine elektronische Anordnung mit zwei einander gegenüberliegenden Deckelelementen, deren Rand je eine umlaufende fettgefüllte Nut besitzt, im Querschnitt;
- Figur 6: zeigt die aus Figur 1 bekannte elektronische Anordnung, bei dem die Anschlusspins mit Fett derart umschlossen sind, dass die Anschlusspins erkennbar sind, in einer 3D-Ansicht;
- Figur 7: zeigt ausschnittsweise die aus Figur 1 bekannte elektronische Anordnung, bei der die benachbarten Anschlusspins mit einer aus Fett gebildeten Trennwand voneinander getrennt sind, in einer 3D-Ansicht; und
- Figur 8: zeigt die aus den Figuren 2 bis 7 bekannte elektronische Anordnung in einem Automatikgetriebe angeordnet, im Röntgenblick.

### Detaillierte Beschreibung beispielhafter Ausführungsformen

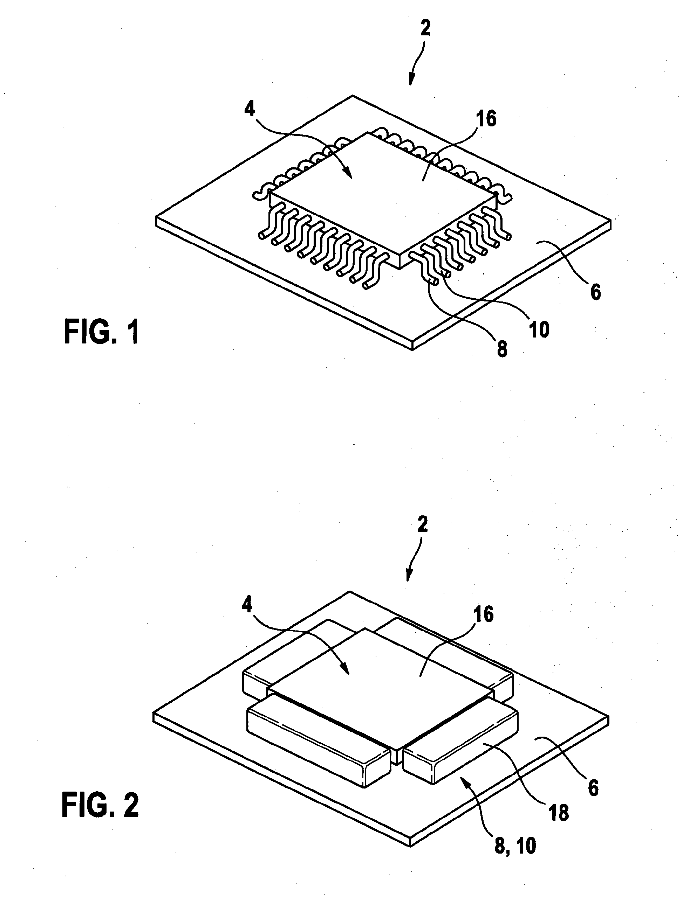

Figur 1 zeigt ein Steuergerät 2 für ein Kraftfahrzeug nach dem Stand der Technik. Das Steuergerät 2 besitzt ein elektronisches Bauelement 4 mit einem ersten Anschlusspin 8 und mit einem zweiten Anschlusspin 10 sowie eine Leiterplatte 6. Der erste Anschlusspin 8 und der zweite Anschlusspin 10 sind einander benachbart. Der erste 8 und der zweite Anschlusspin 10 sind je an der Leiterplatte 6 mittels SMT (Surface-Mounted-Technology) elektrisch leitfähig verbunden. Die Anschlusspins 8, 10 erstrecken sich hierbei von einem Bauelementgehäuse 16 bis zu der Leiterplatte 6.

Figur 2 zeigt die aus Figur 1 bekannte als Steuergerät 2 ausgebildete elektronische Anordnung, bei der die Anschlusspins 8, 10 mit einem elektrisch nicht leitfähigen, fluidbeständigen, synthetischen und hochviskosen Fett 18 derart umschlossen sind, dass die Anschlusspins 8, 10 nicht erkennbar sind. In dem hier vorliegenden Ausgestaltungsbeispiel ist das Fett 18 mittels eines Dispensers aufgetragen. Hierbei verbindet sich das Fett 18 mit dem Anschlusspin 8, 10 derart adhäsiv, dass das Fett 18 durch Fluideinflüsse nicht weggespült wird. Außerdem reagiert das Fett 18 nicht mit dem Fluid, so dass ein Hineindiffundieren von Fluid durch das Fett 18 zu den Anschlusspins 8, 10 vermieden ist. Insbesondere ist das Fett 18 inert gegenüber Automatikgetriebeöl. Das Fett 18 ist aus einem perfluorierten Grundöl in Form eines Perfluorpolyetheröls (PFPE-Öl) und einem fluororganischen Eindicker in Form eines pulverförmigen Polytetrafluorethylens (PTFE-Pulver) zusammengesetzt. Auch besitzt das Fett 18 eine derart geringe Oberflächenspannung, dass elektrisch leitende Verbindungen in Form von Schwebstoffen an dem Fett 18 nicht anhaften können. Ferner ist das Fett 18 derart hochviskos, dass eine elektrisch leitfähige Verbindung in Form von einem Span nicht durch das Fett 18 an die Anschlusspins 8, 10 gelangen kann. Ferner ist das Fett 18 auch an die als Leiterplatte 6 ausgebildete elektrische Verbindungsstruktur adhäsiv verbunden. Die elektrische Verbindungsstruktur kann neben der Ausbildung als starre Leiterplatte auch als flexible Leiterplatte, als Stanzgitter, als umspritztes Stanzgitter, als MID(molded interconnect devices) oder als wenigstens zwei elektrische Leitungen augebildet sein. In der Regel werden die elektrischen Leitungen zu einem Kabelbaum gebunden. Das elektrisch leitfähige Verbinden des elektronischen Bauelements an den Kabelbaum erfolgt in bekannter Weise. Auch kann das elektronische Bauelement seinerseits als wenigstens zwei elektrische Leitungen ausgebildet sein.

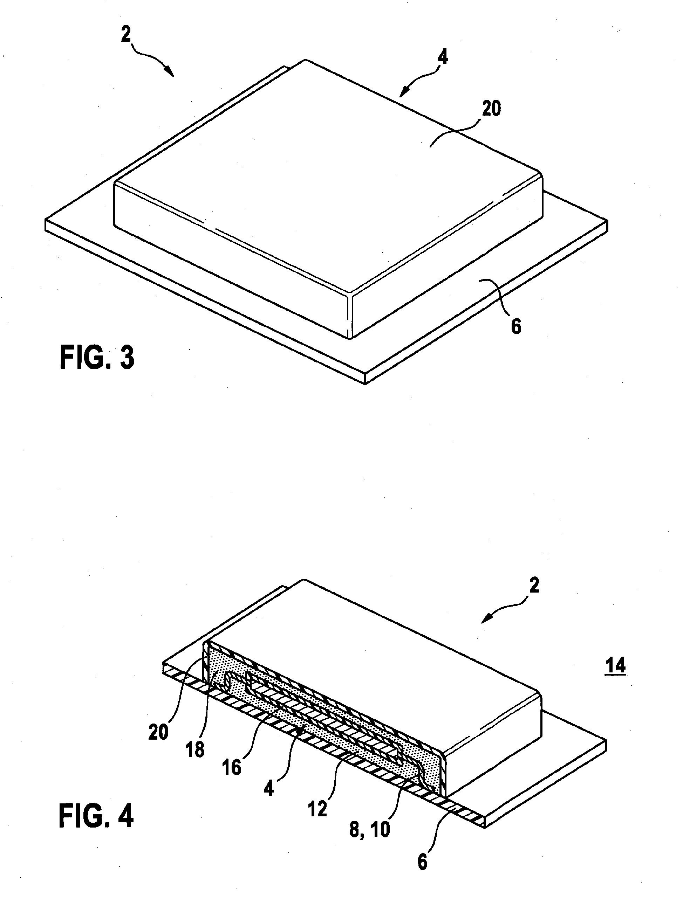

Figur 3 zeigt das aus Figur 2 bekannte Steuergerät 2, dessen elektronisches Bauelement 4 von einem Deckelelement 20 umschlossen ist. Durch das Deckelelement 20 wird ein versehentliches Berühren des Fetts 18 durch Servicepersonal vermieden. Damit ist das Steuergerät 2 möglicherweise gegenüber der in Figur 2 gezeigten Darstellung besser handhabbar.

Figur 4 zeigt das aus Figur 3 bekannte Steuergerät 2 im Querschnitt. Hierbei ist ersichtlich, dass das Deckelelement 20 vollständig mit dem Fett 18 ausgefüllt ist. Demzufolge sind nicht nur die Anschlusspins 8, 10 von dem Fett 18 überdeckt, sondern auch das Bauelementgehäuse 16. Durch das Deckelelement 20 und die Leiterplatte 6 wird ein Innenraum 12 begrenzt, wobei das elektronische Bauelement 4 in dem Innenraum 12 angeordnet ist. Der Innenraum 12 ist von einem Außenraum 14 umschlossen, wobei der Außenraum auch das Steuergerät 2 umgibt.

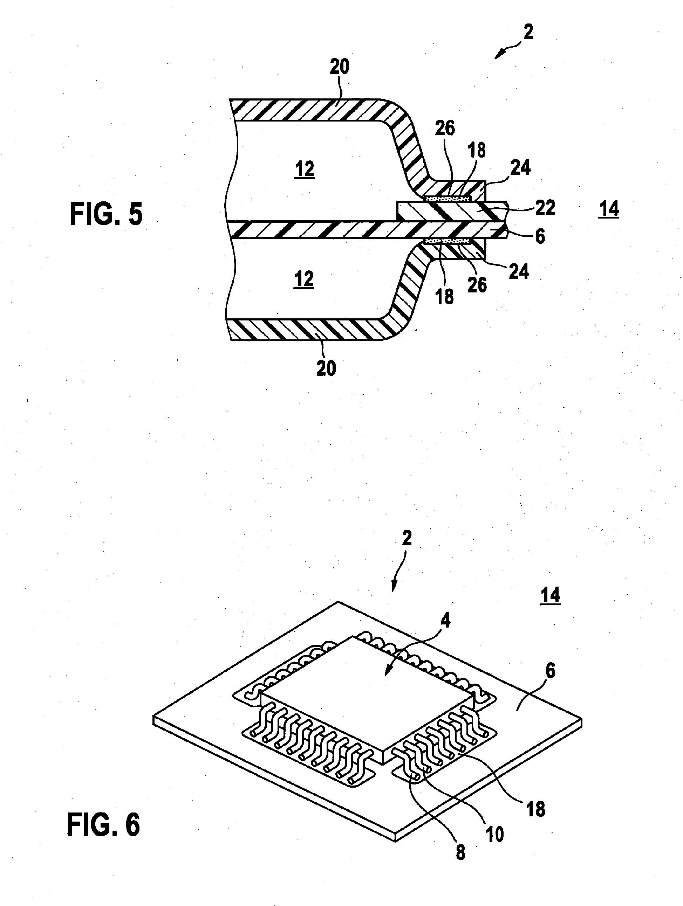

Figur 5 zeigt das Steuergerät 2 mit zwei bezüglich der Leiterplatte 6 einander gegenüberliegend angeordnete Deckelelemente 20. Die Leiterplatte 6 ist mit einer Trägerplatte 20 unlösbar und fluiddicht verbunden. Jedes Deckelelement 20 besitzt einen der Leiterplatte 6 zugewandten Rand 24. In dem Rand 24 ist eine umlaufende Nut 26 angeordnet, die mit dem Fett 18 gefüllt ist. Der Rand 24 ist in der oberen Darstellung der Trägerplatte 22 benachbart, wohingegen in der unteren Darstellung der Rand 24 der Leiterplatte 6 benachbart ist. Die Funktionalität ist in beiden Ausgestaltungen die gleiche. Durch das umlaufende Fett 18 ist der Innenraum 12 von dem Außenraum 14 derart getrennt, dass sich in dem Außenraum 14 befindendes Fluid, respektive Automatikgetriebeöl, nicht von dem Außenraum 14 durch das Fett 18 hindurch in den Innenraum 12 gelangen kann. Die Nut 26 bewirkt, dass der Rand 24 des Deckelelements 20 an die Leiterplatte 6, respektive an die Trägerplatte 22, montiert werden kann, ohne dass das Fett 18 verdrängt wird. Bei einer Verdrängung des Fetts 18 aus dem Rand 24 könnte eine fluiddichte Trennung des Innenraums 12 zu dem Außenraum 14 nicht mehr gewährleistet sein.

Figur 6 zeigt die aus Figur 2 bekannte Darstellung, wobei in der hier gewählten Darstellung das Fett 18 gesprayt bzw. vernebelt aufgetragen wurde. Dementsprechend ist die in Figur 6 aufgetragene Fettmenge 18 geringer als die in Figur 2 aufgetragene. Insbesondere sind bei einer gesprayten Auftragung des Fetts 18 Konturen der Anschlusspins 8, 10 erkennbar.

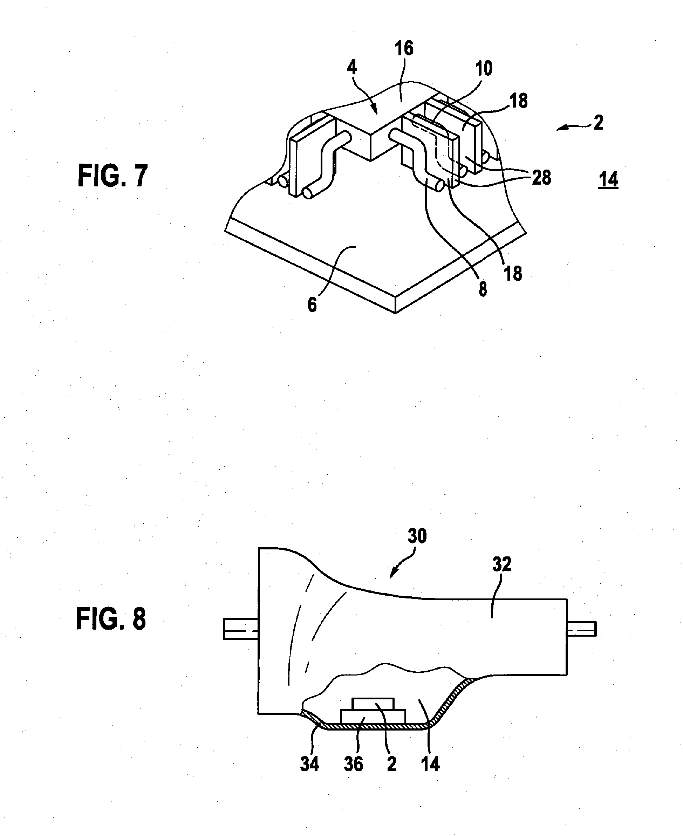

Figur 7 zeigt einen Ausschnitt aus dem Steuergerät 2, bei dem der erste 8 und der zweite Anschlusspin 10 voneinander durch eine aus dem Fett 18 gebildete Trennwand 28 voneinander getrennt sind. Hierbei ist die Trennwand 28 höher und länger ausgebildet als die Anschlusspins 8, 10 hoch und lang sind. Somit können die beiden einnader benachbarten Anschlusspins 8, 10 aufgrund der Trennwand 28 nicht mittels der elektrisch leitfähigen Verbindung in Form eines Spans oder einer Ablagerung miteinander elektrisch leitfähig verbunden werden. Die aus dem Fett 18 gebildete Trennwand 28 ist an dem Bauelementgehäuse 16 sowie an der Leiterplatte 6 fest verbunden. Ferner berührt die Trennwand 28 weder den ersten 8 noch den zweiten Anschlusspin 10.

Figur 8 zeigt ein Automatikgetriebe 30 mit einem Getriebegehäuse 32 und einer Ölwanne 34. Hierbei ist das aus den Figuren 2 bis 7 bekannte Steuergerät 2 in dem Getriebegehäuse 32 in der Ölwanne 34 angeordnet, wobei das Steuergerät 2 an eine Hydraulikplatte 36 gut wärmeleitfähig verbunden ist.

Durch das Fett 18 sind verschiedenste Dichtgeometrien realisierbar, in denen eine elektrisch leitfähige Verbindung zwischen dem ersten 8 und dem zweiten Anschlusspin 10 in Form von Spänen oder Ablagerungen vermieden sind. Ferner können Spalte zwischen Teilen, die bisher fertigungsbedingt oder durch thermische Dehnung aufgetreten sind, durch ein Füllen mit dem Fett 18, insbesondere, wenn das Fett 18 mit dem Deckelelement 20 verpresst wird, vermieden werden, da das Fett 18 reversibel elastisch verformbar ist. Das Fett 18 ist im Fertigungsprozess direkt verwendbar, da eine 2-Komponenten-Anmischung wie beispielsweise bei Polyurethan-Füllstoffen nicht notwendig ist. Da keine chemische Reaktion stattfindet, ist die Topfzeit des Fetts 18 theoretisch unendlich hoch. Ferner fließt das Fett 18 aufgrund seiner hohen Viskosität in der Fertigung nicht weg und tropft nicht. Damit ist eine verschmutzungsfreie Fertigung möglich. Ferner erfüllt das Fett 18 alle Anforderungen an einen Füllstoff, der zum Schutz vor elektrisch leitfähigen Verbindungen wie Spänen und leitenden Ablagerungen in einem Steuergerät 2 zur Steuerung des Automatikgetriebes 30 eingesetzt werden soll. Ferner ist das Fett 18 bis zu Maximaltemperaturen von ca. 300°C gesundheitlich unbedenklich, da inert. Zusätzlich können die in dem Fett 18 enthaltenen Perfluorpolyetheröle zur Mehrung des Schaumhemmeradditivs verwendet werden.

## Patentansprüche

1. Elektronische Anordnung für ein Kraftfahrzeug, wobei die elektronische Anordnung ein elektronisches Bauelement (4) mit einem ersten Anschlusspin (8) und mit einem zweiten Anschlusspin (10) und eine elektrische Verbindungstruktur (6) aufweist,
wobei der erste Anschlusspin (8) und der zweite Anschlusspin (10) einander benachbart sind
wobei der erste Anschlusspin (8) und der zweite Anschlusspin (10) je an der elektrischen Verbindungstruktur (6) elektrisch leitfähig verbunden sind, **dadurch gekennzeichnet, dass**
durch ein elektrisch nicht leitfähiges, fluidbeständiges und synthetisches Fett (18) eine Belegung mit einer elektrisch leitfähigen Verbindung zwischen dem ersten Anschlusspin (8) und dem zweiten Anschlusspin (10) verhindert ist.

2. Elektronische Anordnung nach Anspruch 1,
**dadurch gekennzeichnet, dass**
das Fett (18) sich aus einem perfluorierten Grundöl und einem fluororganischen Eindicker zusammensetzt.

3. Elektronische Anordnung nach Anspruch 2,
**dadurch gekennzeichnet, dass**
das perfluorierten Grundöl Perfluorpolyetheröl (PFPE-Öl) und der fluororganische Eindicker pulverförmiges Polytetrafluorethylen (PTFE-Pulver) ist.

4. Elektronische Anordnung nach Anspruch 2 oder 3,
**dadurch gekennzeichnet, dass**
das perfluorierten Grundöl eine Viskosität aufweist, die größer als 100mm²/s bei 40°C ist.

5. Elektronische Anordnung nach einem der vorhergehenden Ansprüche,
**dadurch gekennzeichnet, dass**
das Fett (18) eine Viskosität von 1 bis 6 nach NLGI-Klasse aufweist.

6. Elektronische Anordnung nach einem der vorhergehenden Ansprüche,
**dadurch gekennzeichnet, dass**
das Fett (18) an den ersten Anschlusspin (8) und/oder an den zweiten Anschlusspin (10) fest verbunden ist.

7. Elektronische Anordnung nach einem der Ansprüche 1 bis 5,
**dadurch gekennzeichnet, dass**
sich das Fett (18) trennwandartig zwischen dem ersten Anschlusspin (8) und dem zweiten Anschlusspin (10) an der elektrischen Verbindungstruktur (6) erstreckt,
wobei das Fett (18) von dem ersten Anschlusspin (8) und dem zweiten Anschlusspin (10) beabstandet ist.

8. Elektronische Anordnung nach Anspruch 6 oder 7,
**dadurch gekennzeichnet, dass**
ein Deckelelement (20) mit der elektrischen Verbindungstruktur (6) verbunden ist,
wobei das Deckelelement (20) und die elektrische Verbindungstruktur (6) einen Innenraum (12) begrenzen,
wobei das elektronische Bauelement (4) in dem Innenraum (12) angeordnet ist.

9. Elektronische Anordnung nach Anspruch 1 bis 5,
**dadurch gekennzeichnet, dass**
ein Deckelelement (20) mit der elektrischen Verbindungstruktur (6) verbunden ist,
wobei das Deckelelement (20) und die elektrische Verbindungstruktur (6) einen Innenraum (12) begrenzen,
wobei der Innenraum (12) von einem Außenraum (14) umschlossen ist, wobei das elektronische Bauelement (4) in dem Innenraum (12) angeordnet ist,
wobei das Fett (18) an dem Deckelelement (20) und der elektrischen Verbindungstruktur (6) umlaufend derart fest verbunden ist, dass ein Eindringen von Fluid aus dem Außenraum (14) in den Innenraum (12) verhindert ist.

10. Elektronische Anordnung nach einem der vorhergehenden Ansprüche,
**dadurch gekennzeichnet, dass**
die elektrische Verbindungstruktur (6) ausgewählt ist aus der Gruppe von starre Leiterplatte, flexible Leiterplatte, Stanzgitter, umspritztes Stanzgitter, MID(molded interconnect devices) und wenigstens zwei elektrische Leitungen.

11. Automatikgetriebe mit einer elektronischen Anordnung nach einem der Ansprüche 1 bis 10
**dadurch gekennzeichnet, dass**
das Automatikgetriebe (30) ein Getriebegehäuse (32) aufweist,
wobei eine elektronische Anordnung (2) nach einem der Ansprüche 1 bis 10 innerhalb des Getriebegehäuses (32) angeordnet ist.

12. Verwendung eines Fetts aus Perfluorpolyetheröl (PFPE-Öl) und pulverförmigen Polytetrafluorethylen (PTFE-Pulver) für eine elektronische Anordnung (2) für ein Kraftfahrzeug nach einem der Ansprüche 1 bis 10 zum Schutz von wenigstens einem Anschlusspin (8, 10) eines elektronischen Bauelements (4) vor einer Belegung mit einer elektrisch leitfähigen Komponente.

## Claims

1. Electronic arrangement for a motor vehicle, wherein the electronic arrangement has an electronic component (4) with a first connection pin (8) and with a second connection pin (10), and has an electrical connecting structure (6), wherein the first connection pin (8) and the second connection pin (10) are adjacent to one another, wherein the first connection pin (8) and the second connection pin (10) are each electrically conductively connected to the electrical connecting structure (6), **characterized in that** a coating with an electrically conductive connection between the first connection pin (8) and the second connection pin (10) is prevented by an electrically non-conductive, fluid-resistant and synthetic grease (18).

2. Electronic arrangement according to Claim 1, **characterized in that** the grease (18) is composed of a perfluorinated base oil and a fluoroorganic thickener.

3. Electronic arrangement according to Claim 2, **characterized in that** the perfluorinated base oil is perfluoropolyether oil (PFPE oil) and the fluoroorganic thickener is pulverulent polytetrafluoroethylene (PTFE powder).

4. Electronic arrangement according to Claim 2 or 3, **characterized in that** the perfluorinated base oil has a viscosity which is greater than 100 mm²/s at 40°C.

5. Electronic arrangement according to one of the preceding claims, **characterized in that** the grease (18) has a viscosity of NLGI grade 1 to 6.

6. Electronic arrangement according to one of the preceding claims, **characterized in that** the grease (18) is firmly bonded to the first connection pin (8) and/or to the second connection pin (10).

7. Electronic arrangement according to one of Claims 1 to 5, **characterized in that** the grease (18) extends in the manner of a separating wall between the first connection pin (8) and the second connection pin (10) on the electrical connecting structure (6), wherein the grease (18) is at a distance from the first connection pin (8) and the second connection pin (10).

8. Electronic arrangement according to Claim 6 or 7, **characterized in that** a cover element (20) is connected to the electrical connecting structure (6), wherein the cover element (20) and the electrical connecting structure (6) delimit an interior space (12), wherein the electronic component (4) is arranged in the interior space (12).

9. Electronic arrangement according to Claims 1 to 5, **characterized in that** a cover element (20) is connected to the electrical connecting structure (6), wherein the cover element (20) and the electrical connecting structure (6) delimit an interior space (12), wherein the interior space (12) is surrounded by an exterior space (14), wherein the electronic component (4) is arranged in the interior space (12), wherein the grease (18) is firmly bonded to the periphery of the cover element (20) and the electrical connecting structure (6) in such a way that the ingress of fluid from the exterior space (14) into the interior space (12) is prevented.

10. Electronic arrangement according to one of the preceding claims, **characterized in that** the electrical connecting structure (6) is selected from the group comprising rigid printed circuit boards, flexible printed circuits, stamped grids, injection-moulded stamped grids, MIDs (moulded interconnect devices) and at least two electrical lines.

11. Automatic transmission having an electronic arrangement according to one of Claims 1 to 10, **characterized in that** the automatic transmission (30) has a transmission housing (32), wherein an electronic arrangement (2) according to one of Claims 1 to 10 is arranged within the transmission housing (32).

12. Use of a grease comprising perfluoropolyether oil (PFPE oil) and pulverulent polytetrafluoroethylene (PTFE powder) for an electronic arrangement (2) for a motor vehicle according to one of Claims 1 to 10 for protecting at least one connection pin (8, 10) of an electronic component (4) against a coating with an electrically conductive component.

## Revendications

1. Ensemble électronique pour véhicule automobile, l'ensemble électronique présentant un composant électronique (4) doté d'une première borne de raccordement (8) et d'une deuxième borne de raccordement (10) ainsi que d'une structure (6) de raccordement électrique,
la première borne de raccordement (8) et la deuxième borne de raccordement (10) étant voisines l'une de l'autre,
la première borne de raccordement (8) et la deuxième borne de raccordement (10) étant raccordées chacune de manière électriquement conductrice à la structure (6) de raccordement électrique,
**caractérisé en ce que**
l'occupation de l'espace situé entre la première borne de raccordement (8) et la deuxième borne de raccordement (10) par un raccordement électriquement conducteur est empêchée par une graisse synthétique (18) électriquement non conductrice et résistante aux fluides.

2. Ensemble électronique selon la revendication 1, **caractérisé en ce que** la graisse (18) est constituée d'une huile de base perfluorée et d'un épaississant organique fluoré.

3. Ensemble électronique selon la revendication 2, **caractérisé en ce que** l'huile de base perfluorée est une huile de polyperfluoroéther (huile PFPE) et l'épaississant organique fluoré du polytétrafluoroéthylène en poudre (poudre de PTFE).

4. Ensemble électronique selon les revendications 2 ou 3, **caractérisé en ce que** l'huile de base perfluorée présente à 40°C une viscosité supérieure à 100 mm²/s.

5. Ensemble électronique selon l'une des revendications précédentes, **caractérisé en ce que** la graisse (18) présente une viscosité de 1 à 6 selon la classification NLGI.

6. Ensemble électronique selon l'une des revendications précédentes, **caractérisé en ce que** la graisse (18) est reliée solidairement à la première borne de raccordement (8) et/ou à la deuxième borne de raccordement (10).

7. Ensemble électronique selon l'une des revendications 1 à 5, **caractérisé en ce que** la graisse (18) s'étend en forme de cloison de séparation sur la structure (6) de raccordement électrique entre la première borne de raccordement (8) et la deuxième borne de raccordement (10) et **en ce que** la graisse (18) est maintenue à distance de la première borne de raccordement (8) et de la deuxième borne de raccordement (10).

8. Ensemble électronique selon les revendications 6 ou 7, **caractérisé en ce qu'**un élément de recouvrement (20) est raccordé à la structure (6) de raccordement électrique, **en ce que** l'élément de recouvrement (20) et la structure (6) de raccordement électrique délimitent un espace intérieur (12) et **en ce que** le composant électronique (4) est disposé dans l'espace intérieur (12).

9. Ensemble électronique selon les revendications 1 à 5, **caractérisé en ce qu'**un élément de recouvrement (20) est raccordé à la structure (6) de raccordement électrique, **en ce que** l'élément de recouvrement (20) et la structure (6) de raccordement électrique délimitent un espace intérieur (12), **en ce que** l'espace intérieur (12) est entouré par un espace extérieur (14), **en ce que** le composant électrique (4) est disposé dans l'espace intérieur (12) et **en ce que** la graisse (18) est reliée solidairement autour de l'élément de recouvrement (20) et de la structure (6) de raccordement électrique de manière à empêcher la pénétration du fluide depuis l'espace extérieur (14) jusque dans l'espace intérieur (12).

10. Ensemble électronique selon l'une des revendications précédentes, **caractérisé en ce que** la structure (6) de raccordement électrique est sélectionnée dans l'ensemble formé des cartes de circuit rigides, des cartes de circuit flexibles, des grilles estampées, des grilles estampées encapsulées, des MID ("molded interconnect devices" - dispositifs d'interconnexion moulés) et d'au moins deux conducteurs électriques.

11. Transmission automatique dotée d'un ensemble électronique selon l'une des revendications 1 à 10, **caractérisée en ce que** la transmission automatique (30) présente un boîtier (32) de transmission et **en ce qu'**un ensemble électronique (2) selon l'une des revendications 1 à 10 est disposé à l'intérieur du boîtier de transmission (32).

12. Utilisation d'une graisse en huile de polyperfluoroéther (huile de PFPE) et de polytétrafluoroéthylène en poudre (poudre de PTFE) pour un ensemble électronique (2) de véhicule automobile selon l'une des revendications 1 à 10, pour protéger au moins une borne de raccordement (8, 10) d'un composant électronique (4) d'une occupation par un composant électriquement conducteur.
